# EUROPEAN PATENT APPLICATION

(11) **EP 4 692 942 A1**
(43) Date of publication of application: **11.02.2026**
(21) Application number: 24780276.2
(22) Date of filing: 26.03.2024
(51) Int. Cl.: G03F 7/11, C08G 8/04, H01L 21/027

(54) **COMPOSITION FOR FORMING RESIST UNDERLAYER FILM**

(30) Priority: 31.03.2023 JP 2023058036
(71) Applicant: Nissan Chemical Corporation, Tokyo 103-6119 (JP)
(72) Inventor: SHIMIZU, Shou, Toyama-shi, Toyama 939-2792 (JP); OGATA, Hiroto, Toyama-shi, Toyama 939-2792 (JP)
(74) Representative: Hoffmann Eitle
(86) International application number: PCT/JP2024/011894
(87) International publication number: WO 2024/204163

(57) **Abstract**

A resist underlayer film-forming composition comprising:
a novolac resin (A) having a phenolic hydroxy group and a halogen atom directly bonded to an aromatic hydrocarbon ring; and
a solvent (B).

## Description

### Technical Field

The present invention relates to a resist underlayer film-forming composition, a resist underlayer film, a laminate, a semiconductor element producing method, and a pattern forming method.

### Background Art

In the related art, fine processing by lithography using a resist composition has been performed in the production of semiconductor devices. The fine processing is a processing method in which a thin film of a photoresist composition is formed on a semiconductor substrate such as a silicon wafer, irradiated with active rays such as ultraviolet rays through a mask pattern with a device pattern drawn thereon, and developed, and the substrate is etched using the obtained photoresist pattern as a protective film to form fine irregularities corresponding to the photoresist pattern on a surface of the substrate. In recent years, the degree of integration of semiconductor devices has been increased, and as active rays to be used, EUV light (wavelength: 13.5 nm) or an electron beam (EB) has been studied to be put into practical use for the most advanced fine processing, in addition to i-rays (wavelength: 365 nm), a KrF excimer laser (wavelength: 248 nm), and an ArF excimer laser (wavelength: 193 nm) which have been used in the related art. At the same time, defects in the formation of the resist pattern due to an influence from the semiconductor substrate and the like are a big problem. Therefore, in order to solve this problem, a method of providing a resist underlayer film between a resist and a semiconductor substrate has been widely studied.

Patent Literature 1 discloses an underlayer film-forming composition for lithography containing a naphthalene ring having a halogen atom. Patent Literature 2 discloses a halogenated antireflective film. Patent Literature 3 discloses a resist underlayer film-forming composition.

### Citation List

### Patent Literatures

Patent Literature 1: WO 2006/003850 A
Patent Literature 2: JP 2005-526270 A
Patent Literature 3: WO 2020/111068 A

### Summary of Invention

### Technical Problem

Examples of the characteristics required for a resist underlayer film include no occurrence of intermixing with a resist film formed on an upper layer (being insoluble in a resist solvent), ability to form a resist pattern with high sensitivity, and a high etching rate.

The present invention has been made in view of the above circumstances, and an object of the present invention is to provide a resist underlayer film-forming composition capable of forming a resist underlayer film which has a high etching rate and on which a resist pattern can be formed with high sensitivity, and a resist underlayer film, a laminate, a semiconductor element producing method, and a pattern forming method using the resist underlayer film-forming composition.

### Solution to Problem

The inventors have conducted intensive studies to solve the above-described problems. As a result, they have found that the above-described problems can be solved and have completed the present invention having the following gist.

That is, the present invention includes the following aspects.
[1] A resist underlayer film-forming composition including: a novolac resin (A) having a phenolic hydroxy group and a halogen atom directly bonded to an aromatic hydrocarbon ring; and a solvent (B).
[2] The resist underlayer film-forming composition according to [1], wherein the novolac resin (A) has a repeating unit represented by Formula (1) shown below. 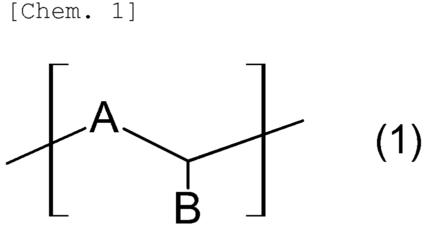 (In Formula (1), A represents an aromatic hydrocarbon ring having a phenolic hydroxy group (the aromatic hydrocarbon ring may have a substituent).
   B represents an aromatic hydrocarbon group to which at least one of a bromine atom and an iodine atom is directly bonded (the aromatic hydrocarbon group may have a substituent))
[3] The resist underlayer film-forming composition according to [2], wherein A in Formula (1) shown above is represented by Formula (1-1) shown below. 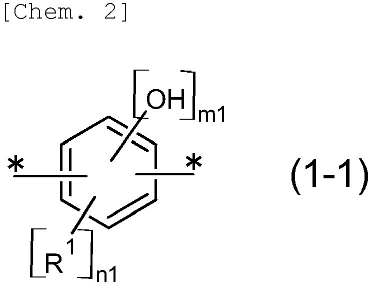 (In Formula (1-1), m1 represents an integer of 1 to 4.
   n1 represents an integer of 0 to 3.
   n1 + m1 is 4 or less.
   R¹ represents an alkyl group having 1 to 6 carbon atoms or an alkoxy group having 1 to 6 carbon atoms.
   When n1 is 2 or more, two or more R¹'s may be the same or different.
   * represents a bond)
[4] The resist underlayer film-forming composition according to [2] or [3], wherein A in Formula (1) shown above is derived from phloroglucinol which may be substituted.
[5] The resist underlayer film-forming composition according to any one of [2] to [4], wherein B in Formula (1) shown above is represented by Formula (1-2) shown below. 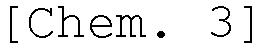 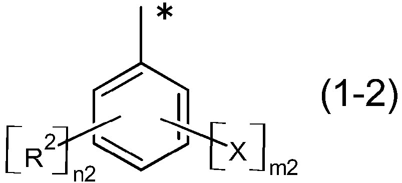 (In Formula (1-2), m2 represents an integer of 1 to 5.
   n2 represents an integer of 0 to 4.
   n2 + m2 is 5 or less.
   X represents a bromine atom or an iodine atom.
   R² represents a hydroxy group, an alkyl group having 1 to 6 carbon atoms, or an alkoxy group having 1 to 6 carbon atoms.
   When n2 is 2 or more, two or more R²'s may be the same or different.
   When m2 is 2 or more, two or more X's may be the same or different.
   * represents a bond)
[6] The resist underlayer film-forming composition according to any one of [1] to [5], wherein, in the halogen atom directly bonded to the aromatic hydrocarbon ring, the halogen atom is a bromine atom.
[7] The resist underlayer film-forming composition according to any one of [1] to [6], further including a crosslinking agent (C).
[8] The resist underlayer film-forming composition according to any one of [1] to [7], which is a resist underlayer film-forming composition for UV or electron beam lithography.
[9] A resist underlayer film which is a cured product of the resist underlayer film-forming composition according to any one of [1] to [8].
[10] The resist underlayer film according to [9], wherein a film thickness is 2 nm or more and 20 nm or less.
[11] A laminate including:
   a semiconductor substrate; and
   the resist underlayer film according to [9] or [10].
[12] A semiconductor element producing method including the steps of:
   forming a resist underlayer film on a semiconductor substrate using the resist underlayer film-forming composition according to any one of [1] to [8]; and
   forming a resist film on the resist underlayer film.
[13] A pattern forming method including the steps of:
   forming a resist underlayer film on a semiconductor substrate using the resist underlayer film-forming composition according to any one of [1] to [8];
   forming a resist film on the resist underlayer film;
   irradiating the resist film with light or electron beams, and then developing the resist film to obtain a resist pattern; and
   etching the resist underlayer film using the resist pattern as a mask.

### Advantageous Effects of Invention

According to the present invention, it is possible to provide a resist underlayer film-forming composition capable of forming a resist underlayer film which has a high etching rate and on which a resist pattern can be formed with high sensitivity, and a resist underlayer film, a laminate, a semiconductor element producing method, and a pattern forming method using the resist underlayer film-forming composition.

### Description of Embodiments

### (Resist Underlayer Film-Forming Composition)

A resist underlayer film-forming composition of the present invention contains a novolac resin (A) and a solvent (B).

The resist underlayer film-forming composition may contain a crosslinking agent (C), a curing catalyst (D), and the like.

### <Novolac Resin (A)>

The novolac resin (A) has a phenolic hydroxy group and a halogen atom directly bonded to an aromatic hydrocarbon ring.

Since the novolac resin (A) has both the phenolic hydroxy group and the halogen atom directly bonded to an aromatic hydrocarbon ring, it is possible to form a resist underlayer film which has a high etching rate and on which a resist pattern can be formed with high sensitivity, compared to cases where the novolac resin has no halogen atom directly bonded to an aromatic hydrocarbon ring.

Examples of the halogen atom directly bonded to an aromatic hydrocarbon ring include a fluorine atom, a chlorine atom, a bromine atom, and an iodine atom. From the viewpoint of suitably obtaining the effects of the present invention, a bromine atom and an iodine atom are preferable, and a bromine atom is more preferable.

The number of halogen atoms directly bonded to one aromatic hydrocarbon ring may be one or two or more.

When the number of halogen atoms directly bonded to one aromatic hydrocarbon ring is two or more, the two or more halogen atoms may be the same or different.

In the present invention, the phenolic hydroxy group is also referred to as an aromatic hydroxy group. The aromatic ring to which a hydroxy group is directly bonded is not limited to a benzene ring, and may be an aromatic hydrocarbon ring such as a naphthalene ring or an anthracene ring, or may be an aromatic heterocyclic ring.

From the viewpoint of suitably obtaining the effects of the present invention, the novolac resin (A) preferably has a repeating unit represented by Formula (1) shown below. 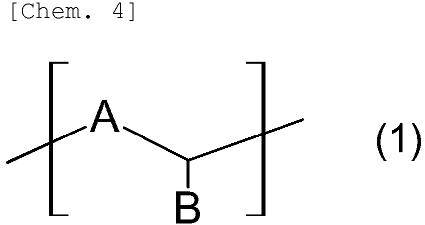 (In Formula (1), A represents an aromatic hydrocarbon ring having a phenolic hydroxy group (the aromatic hydrocarbon ring may have a substituent).
B represents an aromatic hydrocarbon group to which at least one of a bromine atom and an iodine atom is directly bonded (the aromatic hydrocarbon group may have a substituent))

### <<A>>

A in Formula (1) is not particularly limited as long as it is an aromatic hydrocarbon ring having a phenolic hydroxy group.

A in Formula (1) is a divalent group. Therefore, the aromatic hydrocarbon ring having a phenolic hydroxy group can be said to be a divalent group obtained by removing two hydrogen atoms from the aromatic hydrocarbon ring having a phenolic hydroxy group.

The aromatic hydrocarbon ring of A in Formula (1) is not particularly limited, and examples thereof include a benzene ring, a naphthalene ring, an anthracene ring, and a pyrene ring. From the viewpoint of suitably obtaining the effects of the present invention, a benzene ring is preferable.

The number of phenolic hydroxy groups of the aromatic hydrocarbon ring of A in Formula (1) may be one or two or more, and is preferably two or more, and more preferably two to four from the viewpoint of suitably obtaining the effects of the present invention.

The aromatic hydrocarbon ring of A in Formula (1) may have a substituent. The substituent is not particularly limited, and examples thereof include a halogen atom, a carboxyl group, an alkyl group having 1 to 6 carbon atoms, and an alkoxy group having 1 to 6 carbon atoms. The number of substituents of the aromatic hydrocarbon ring is not particularly limited.

A in Formula (1) is preferably represented by Formula (1-1) shown below from the viewpoint of suitably obtaining the effects of the present invention. 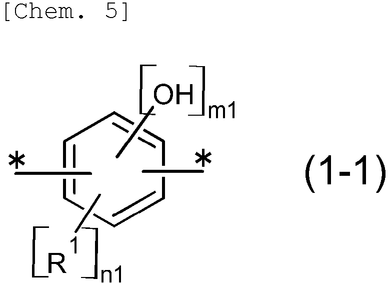 (In Formula (1-1), m1 represents an integer of 1 to 4.
n1 represents an integer of 0 to 3.
n1 + m1 is 4 or less.
R¹ represents an alkyl group having 1 to 6 carbon atoms or an alkoxy group having 1 to 6 carbon atoms.
When n1 is 2 or more, two or more R¹'s may be the same or different.
* represents a bond)

m1 is preferably 2 or 3 from the viewpoint of suitably obtaining the effects of the present invention.

A in Formula (1) is preferably derived from phloroglucinol(1,3,5-trihydroxybenzene) which may be substituted, from the viewpoint of suitably obtaining the effects of the present invention.

A in Formula (1) derived from phloroglucinol which may be substituted is preferably represented by Formula (1-1-1) shown below. 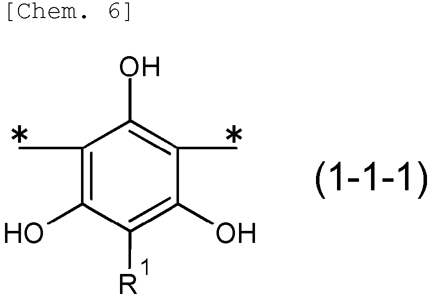 (In Formula (1-1-1), R¹ represents a hydrogen atom, an alkyl group having 1 to 6 carbon atoms, or an alkoxy group having 1 to 6 carbon atoms.
* represents a bond)

In the present specification, the alkyl group having 1 to 6 carbon atoms is preferably an alkyl group having 1 to 4 carbon atoms, and more preferably an alkyl group having 1 to 2 carbon atoms.

In the present specification, examples of the alkyl group having 1 to 6 carbon atoms include a methyl group, an ethyl group, an n-propyl group, an i-propyl group, a cyclopropyl group, an n-butyl group, an i-butyl group, an s-butyl group, a t-butyl group, a cyclobutyl group, a 1-methyl-cyclopropyl group, a 2-methyl-cyclopropyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group.

In the present specification, the alkoxy group having 1 to 6 carbon atoms is preferably an alkoxy group having 1 to 4 carbon atoms, and more preferably an alkoxy group having 1 to 2 carbon atoms.

In the present specification, examples of the alkoxy group having 1 to 20 carbon atoms include a methoxy group, an ethoxy group, a n-propoxy group, an i-propoxy group, a n-butoxy group, an i-butoxy group, a s-butoxy group, a t-butoxy group, an n-pentyloxy group, a 1-methyl-n-butoxy group, a 2-methyl-n-butoxy group, a 3-methyl-n-butoxy group, a 1,1-dimethyl-n-propoxy group, a 1,2-dimethyl-n-propoxy group, a 2,2-dimethyl-n-propoxy group, a 1-ethyl-n-propoxy group, a n-hexyloxy group, a 1-methyl-n-pentyloxy group, a 2-methyl-n-pentyloxy group, a 3-methyl-n-pentyloxy group, a 4-methyl-n-pentyloxy group, a 1,1-dimethyl-n-butoxy group, a 1,2-dimethyl-n-butoxy group, a 1,3-dimethyl-n-butoxy group, a 2,2-dimethyl-n-butoxy group, a 2,3-dimethyl-n-butoxy group, a 3,3-dimethyl-n-butoxy group, a 1-ethyl-n-butoxy group, a 2-ethyl-n-butoxy group, a 1,1,2-trimethyl-n-propoxy group, a 1,2,2-trimethyl-n-propoxy group, a 1-ethyl-1-methyl-n-propoxy group, and a 1-ethyl-2-methyl-n-propoxy group.

### <<B>>

B in Formula (1) is not particularly limited as long as it is an aromatic hydrocarbon group to which at least one of a bromine atom and an iodine atom is directly bonded.

B in Formula (1) is a monovalent group. Therefore, the aromatic hydrocarbon group to which at least one of a bromine atom and an iodine atom is directly bonded can be said to be a monovalent group obtained by removing one hydrogen atom from the aromatic hydrocarbon ring to which at least one of a bromine atom and an iodine atom is directly bonded.

The aromatic hydrocarbon ring of the aromatic hydrocarbon group of B in Formula (1) is not particularly limited, and examples thereof include a benzene ring, a naphthalene ring, an anthracene ring, and a pyrene ring. From the viewpoint of suitably obtaining the effects of the present invention, a benzene ring is preferable.

The number of at least one of the bromine atom and the iodine atom of the aromatic hydrocarbon ring of the aromatic hydrocarbon group of B in Formula (1) may be one or two or more, and is preferably two or more, and more preferably two to five.

The aromatic hydrocarbon ring of the aromatic hydrocarbon group in B in Formula (1) may have a substituent. The substituent is not particularly limited, and examples thereof include a hydroxy group, a carboxyl group, an alkyl group having 1 to 6 carbon atoms, and an alkoxy group having 1 to 6 carbon atoms. The number of substituents is not particularly limited.

B in Formula (1) is preferably represented by Formula (1-2) shown below from the viewpoint of suitably obtaining the effects of the present invention. 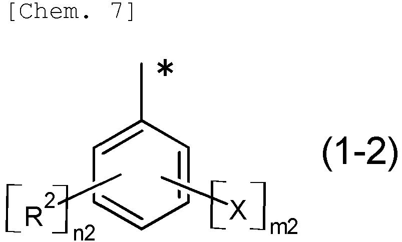 (In Formula (1-2), m2 represents an integer of 1 to 5.
n2 represents an integer of 0 to 4.
n2 + m2 is 5 or less.
X represents a bromine atom or an iodine atom.
R² represents a hydroxy group, an alkyl group having 1 to 6 carbon atoms, or an alkoxy group having 1 to 6 carbon atoms.
When n2 is 2 or more, two or more R²'s may be the same or different.
When m2 is 2 or more, two or more X's may be the same or different.
* represents a bond)

m2 is preferably 2 from the viewpoint of suitably obtaining the effects of the present invention.

The repeating unit represented by Formula (1) is preferably a repeating unit represented by Formula (1X) shown below from the viewpoint of suitably obtaining the effects of the present invention. The novolac resin (A) may have one kind or two or more kinds of repeating units represented by Formula (1X). 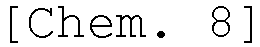 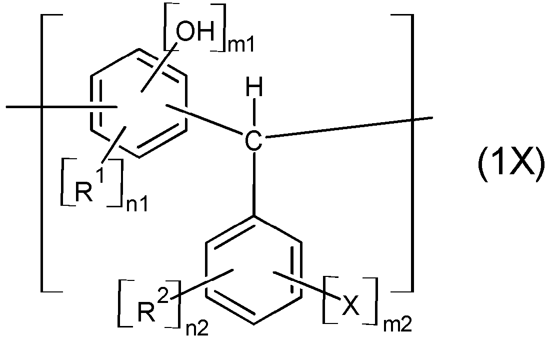 (In Formula (1X), m1 represents an integer of 1 to 4. n1 represents an integer of 0 to 3. n1 + m1 is 4 or less.

R¹ represents an alkyl group having 1 to 6 carbon atoms or an alkoxy group having 1 to 6 carbon atoms.

When n1 is 2 or more, two or more R¹'s may be the same or different.

m2 represents an integer of 1 to 5. n2 represents an integer of 0 to 4. n2 + m2 is 5 or less.

X represents a bromine atom or an iodine atom.

R² represents a hydroxy group, an alkyl group having 1 to 6 carbon atoms, or an alkoxy group having 1 to 6 carbon atoms.

When n2 is 2 or more, two or more R²'s may be the same or different.

When m2 is 2 or more, two or more X's may be the same or different)

Examples of the repeating unit represented by Formula (1) include the following repeating units.

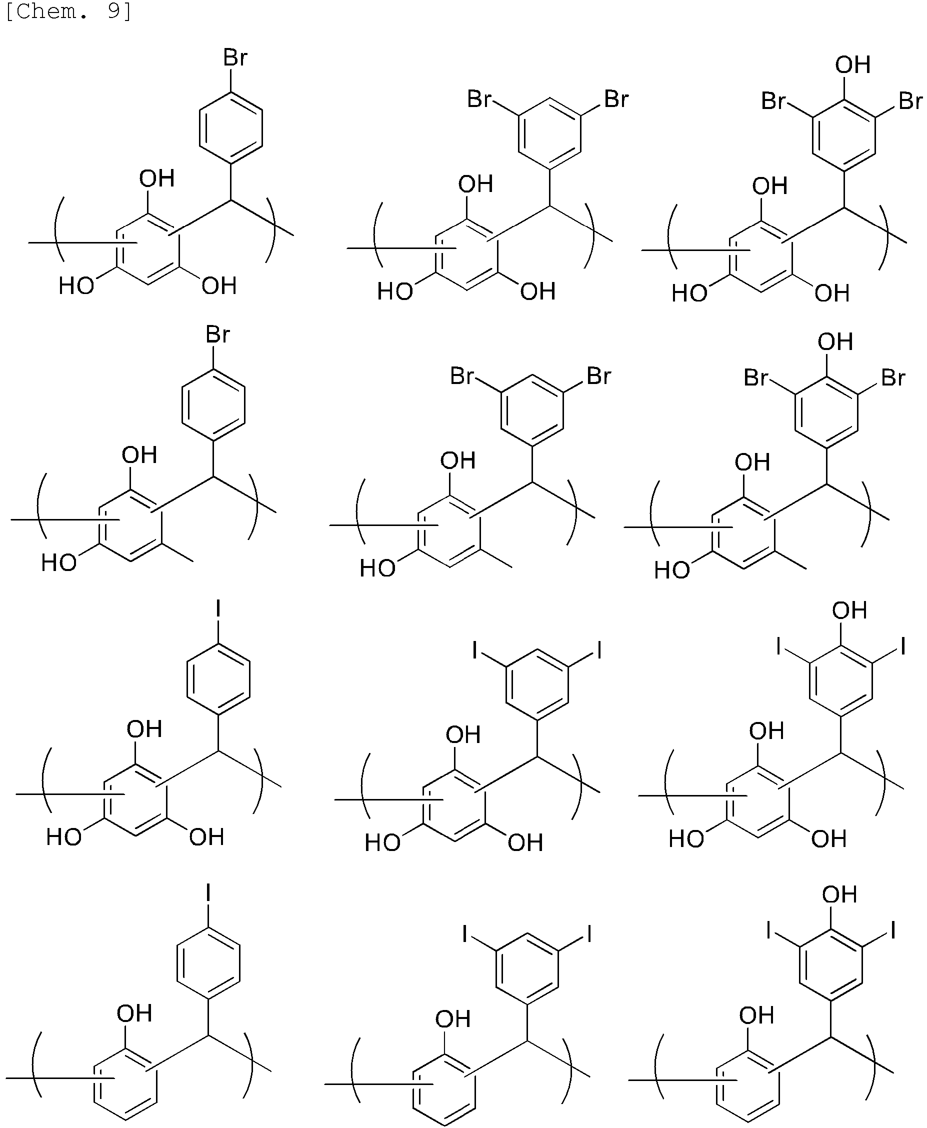

The novolac resin (A) can be synthesized by, for example, the following method.
· Reaction between an aromatic hydrocarbon having a phenolic hydroxy group (phenolic compound A) and a compound represented by Formula (B) shown below as an aldehyde compound B. 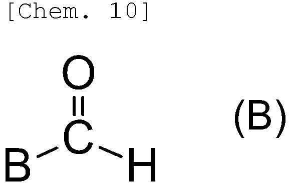 (In Formula (B), B represents an aromatic hydrocarbon group to which a halogen atom is directly bonded (the aromatic hydrocarbon group may have a substituent))

Examples of the phenolic compound A include a compound represented by Formula (A-1) shown below.

By using the compound represented by Formula (A-1), the structure represented by Formula (1-1) is introduced into the novolac resin (A). 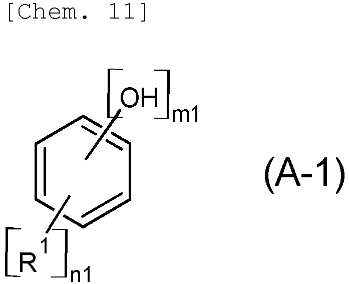 (In Formula (A-1), m1 represents an integer of 1 to 4.
n1 represents an integer of 0 to 3.
n1 + m1 is 4 or less.
R¹ represents an alkyl group having 1 to 6 carbon atoms or an alkoxy group having 1 to 6 carbon atoms.

When n1 is 2 or more, two or more R¹'s may be the same or different)

Examples of the compound represented by Formula (A-1) include catechol, resorcinol, hydroquinone, 2,6-dimethylhydroquinone, pyrogallol, hydroxyquinol, and phloroglucinol.

Examples of the aldehyde compound B include a compound represented by Formula (B-1) shown below.

By using the compound represented by Formula (B-1), the structure represented by Formula (1-2) is introduced into the novolac resin (A). 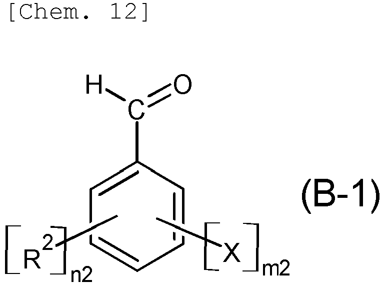 (In Formula (B-1), m2 represents an integer of 1 to 5.
n2 represents an integer of 0 to 4.
n2 + m2 is 5 or less.
X represents a bromine atom or an iodine atom.
R² represents a hydroxy group, an alkyl group having 1 to 6 carbon atoms, or an alkoxy group having 1 to 6 carbon atoms.

When n2 is 2 or more, two or more R²'s may be the same or different.

When m2 is 2 or more, two or more X's may be the same or different)

Examples of the compound represented by Formula (B-1) include 3,5-dibromobenzaldehyde and 3,5-dibromo-4-hydroxybenzaldehyde.

In the condensation reaction of the phenolic compound A and the aldehyde compound B, the aldehyde compound B can be reacted at a ratio of, for example, 0.1 to 10 mol, preferably 0.8 to 2.2 mol, and more preferably 1.0 mol, based on 1 mol of the phenolic compound A.

An acid catalyst can be used in the condensation reaction, and for example, mineral acids such as sulfuric acid, phosphoric acid, and perchloric acid, organic sulfonic acids such as p-toluenesulfonic acid and p-toluenesulfonic acid monohydrate, or carboxylic acids such as formic acid and oxalic acid are used. The amount of the acid catalyst used in the condensation reaction is variously selected depending on the acid kind to be used. The amount of the acid catalyst used is usually 0.001 to 10,000 parts by mass, preferably 0.01 to 1,000 parts by mass, and more preferably 0.1 to 100 parts by mass, based on 100 parts by mass of the total of the phenolic compound A and the aldehyde compound B.

When either the raw material compound or the acid catalyst to be used is a liquid, the condensation reaction can be performed without using a solvent in some cases, but is usually performed using a solvent.

Such a solvent is not particularly limited as long as the reaction is not inhibited, and typical examples thereof include an ether compound, a monoalkyl ether compound, and an ether ester compound.

Examples of the ether compound include cyclic ether compounds such as tetrahydrofuran and dioxane.

Examples of the monoalkyl ether compound include propylene glycol monomethyl ether, diethylene glycol monomethyl ether, diethylene glycol monophenyl ether, triethylene glycol monomethyl ether, and dipropylene glycol monomethyl ether.

Examples of the ether ester compound include methyl cellosolve acetate, ethyl cellosolve acetate, butyl cellosolve acetate, propylene glycol monomethyl ether acetate (PGMEA), propylene glycol monoethyl ether acetate, propylene glycol monopropyl ether acetate, propylene glycol monomethyl ether propionate, propylene glycol monoethyl ether propionate, and propylene glycol monopropyl ether propionate.

The reaction temperature during the condensation is usually 40°C to 200°C. The reaction time is variously selected depending on the reaction temperature and is usually about 30 minutes to 50 hours.

The molecular weight of the novolac resin (A) is not particularly limited.

The lower limit of the weight average molecular weight of the novolac resin (A) is, for example, 500, 1,000, 2,000, or 3,000.

The upper limit of the weight average molecular weight of the novolac resin (A) is, for example, 30,000, 20,000, or 10,000.

The content of the novolac resin (A) in the resist underlayer film-forming composition is not particularly limited, and is preferably 40 mass% to 99 mass%, more preferably 45 mass% to 95 mass%, and particularly preferably 50 mass% to 90 mass% with respect to the film constituent components from the viewpoint of suitably obtaining the effects of the present invention.

In the present invention, the film constituent component means a component other than the solvent contained in the composition.

### <Solvent (B)>

The solvent (B) is not particularly limited, and may be water or an organic solvent.

Examples of the organic solvent include alkylene glycol monoalkyl ether and a monocarboxylic acid ester of alkylene glycol monoalkyl ether.

Examples of the alkylene group of the alkylene glycol monoalkyl ether include an alkylene group having 2 to 4 carbon atoms.

Examples of the alkyl group of the alkylene glycol monoalkyl ether include an alkyl group having 1 to 4 carbon atoms.

The number of carbon atoms of the alkylene glycol monoalkyl ether is, for example, 3 to 8.

Examples of the alkylene glycol monoalkyl ether include ethylene glycol monomethyl ether, ethylene glycol monoethyl ether, propylene glycol monomethyl ether, and propylene glycol monoethyl ether.

Examples of the alkylene group of the monocarboxylic acid ester of the alkylene glycol monoalkyl ether include an alkylene group having 2 to 4 carbon atoms.

Examples of the alkyl group of the monocarboxylic acid ester of the alkylene glycol monoalkyl ether include an alkyl group having 1 to 4 carbon atoms.

Examples of the monocarboxylic acid of the monocarboxylic acid ester of the alkylene glycol monoalkyl ether include a saturated monocarboxylic acid having 2 to 4 carbon atoms.

Examples of the saturated monocarboxylic acid having 2 to 4 carbon atoms include acetic acid, propionic acid, and butyric acid.

The number of carbon atoms of the monocarboxylic acid ester of the alkylene glycol monoalkyl ether is, for example, 5 to 10.

Examples of the monocarboxylic acid ester of the alkylene glycol monoalkyl ether include methyl cellosolve acetate, ethyl cellosolve acetate, propylene glycol monomethyl ether acetate, and propylene glycol propyl ether acetate.

Examples of other organic solvents include diethylene glycol monomethyl ether, diethylene glycol monoethyl ether, propylene glycol, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide.

Among these solvents (B), alkylene glycol monoalkyl ether and a monocarboxylic acid ester of alkylene glycol monoalkyl ether are preferable.

These solvents (B) can be used alone or in combination of two or more thereof.

The mass ratio of the organic solvent in the solvent (B) is not particularly limited, and is preferably 50 mass% to 100 mass%.

The content of the solvent (B) in the resist underlayer film-forming composition is not particularly limited, and is preferably 50 mass% to 99.99 mass%, more preferably 75 mass% to 99.95 mass%, and particularly preferably 90 mass% to 99.9 mass%.

### <Crosslinking Agent (C)>

The crosslinking agent (C) is not particularly limited.

The crosslinking agent (C) has a structure different from that of the novolac resin (A).

As the crosslinking agent (C), an aminoplast crosslinking agent and a phenoplast crosslinking agent are preferable.

The aminoplast crosslinking agent is an addition condensate of a compound having an amino group, such as melamine or guanamine, and formaldehyde.

The phenoplast crosslinking agent is an addition condensate of a compound having a phenolic hydroxy group and formaldehyde.

Examples of the crosslinking agent (C) include a compound having two or more structures shown below. 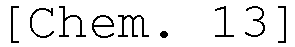 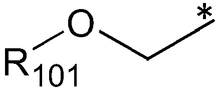 (In the structure, R₁₀₁ represents a hydrogen atom, an alkyl group having 1 to 4 carbon atoms, or an alkoxyalkyl group having 2 to 6 carbon atoms. * represents a bond)

The bond is bonded to, for example, a nitrogen atom, a carbon atom constituting an aromatic hydrocarbon ring, or the like.

As R₁₀₁, a hydrogen atom, a methyl group, an ethyl group, or a group represented by the following structure is preferable. 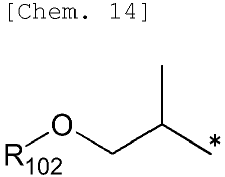 (In the structure, R₁₀₂ represents a hydrogen atom, a methyl group, or an ethyl group. * represents a bond)

The crosslinking agent (C) is preferably a melamine compound, a guanamine compound, a glycoluril compound, a urea compound, or a compound having a phenolic hydroxy group. These can be used alone or in combination of two or more thereof.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

Examples of the glycoluril compound include tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof.

The glycoluril compound may be, for example, a glycoluril derivative represented by Formula (1E) shown below. 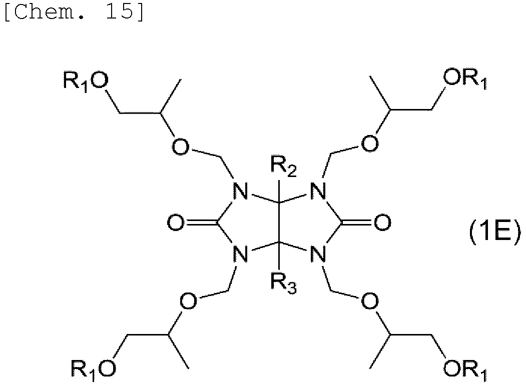 (In Formula (1E), four R¹'s each independently represent a methyl group or an ethyl group, and R₂ and R₃ each independently represent a hydrogen atom, an alkyl group having 1 to 4 carbon atoms, or a phenyl group)

Examples of the glycoluril derivative represented by Formula (1E) shown above include compounds represented by Formulas (1E-1) to (1E-6) shown below.

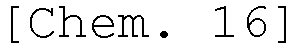

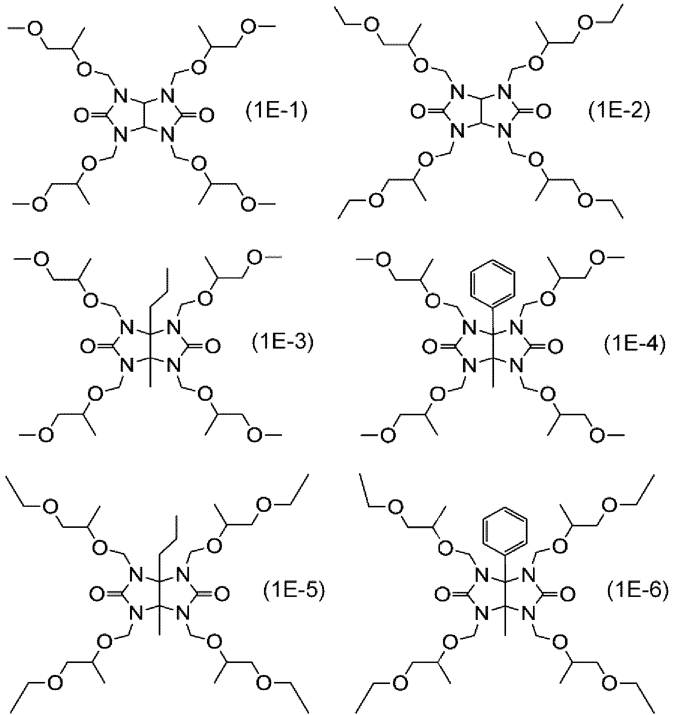

The glycoluril derivative represented by Formula (1E) is obtained, for example, by reacting a glycoluril derivative represented by Formula (2E) shown below with at least one compound represented by Formula (3d) shown below. 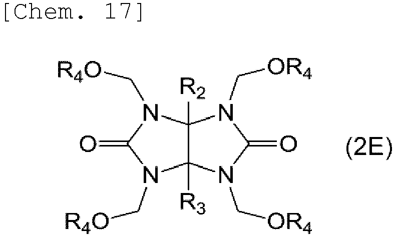 (In Formula (2E), R₂ and R₃ each independently represent a hydrogen atom, an alkyl group having 1 to 4 carbon atoms, or a phenyl group, and R₄'s each independently represent an alkyl group having 1 to 4 carbon atoms) 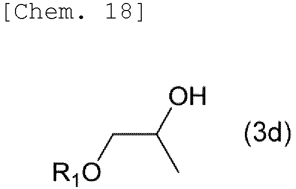 (In Formula (3d), R₁ represents a methyl group or an ethyl group)

Examples of the glycoluril derivative represented by Formula (2E) shown above include compounds represented by Formulas (2E-1) to (2E-4) shown below. Furthermore, examples of the compound represented by Formula (3d) shown above include compounds represented by Formulas (3d-1) and (3d-2) shown below.

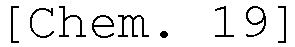

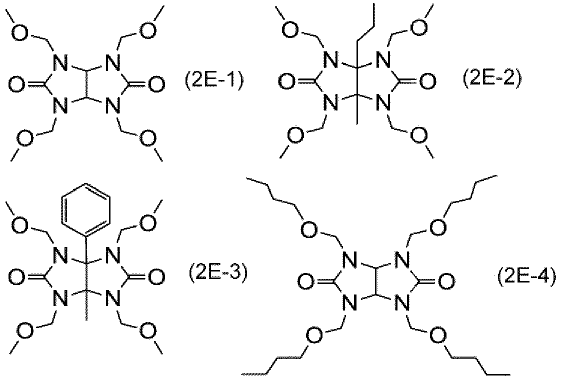

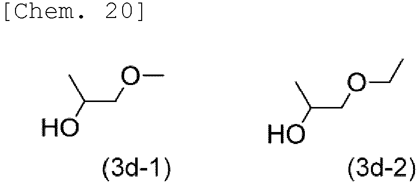

Examples of the urea compound include tetramethylolurea, tetramethoxymethylurea, a compound in which 1 to 4 methylol groups of tetramethylolurea are methoxymethylated or a mixture thereof, and tetramethoxyethylurea.

Examples of the compound having a phenolic hydroxy group include a compound represented by Formula (G-1) or (G-2) shown below. 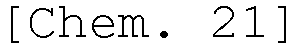 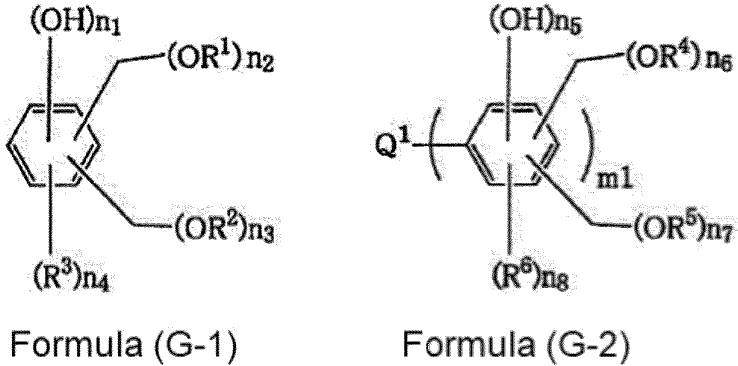
Formula (G-1)
Formula (G-2)
(In Formulas (G-1) and (G-2), Q¹ represents a single bond or an m1-valent organic group.

R¹ and R⁴ each represent an alkyl group having 2 to 10 carbon atoms or an alkyl group having 2 to 10 carbon atoms and having an alkoxy group having 1 to 10 carbon atoms.

R² and R⁵ each represent a hydrogen atom or a methyl group.

R³ and R⁶ each represent an alkyl group having 1 to 10 carbon atoms or an aryl group having 6 to 40 carbon atoms.

n₁ represents an integer that meets 1 ≤ n₁ ≤ 3, n₂ represents an integer that meets 2 ≤ n₂ ≤ 5, n₃ represents an integer that meets 0 ≤ n₃ ≤ 3, n₄ represents an integer that meets 0 ≤ n₄ ≤ 3, and an integer that meets 3 ≤ (n₁ + n₂ + n₃ + n₄) ≤ 6.

n₃ represents an integer that meets 1 ≤ n₃ ≤ 3, n₆ represents an integer that meets 1 ≤ n₆ ≤ 4, n₇ represents an integer that meets 0 ≤ n₇ ≤ 3, n₃ represents an integer that meets 0 ≤ n₃ ≤ 3, and an integer that meets 2 ≤ (n₅ + n₆ + n₇ + n₈) ≤ 5.

m1 represents an integer of 2 to 10)

Examples of the compound having a phenolic hydroxy group include a compound represented by Formula (G-3) or (G-4) shown below.

The compound represented by Formula (G-1) or (G-2) may be obtained by a reaction of a compound represented by Formula (G-3) or (G-4) shown below with a hydroxyl groupcontaining ether compound or an alcohol having 2 to 10 carbon atoms. 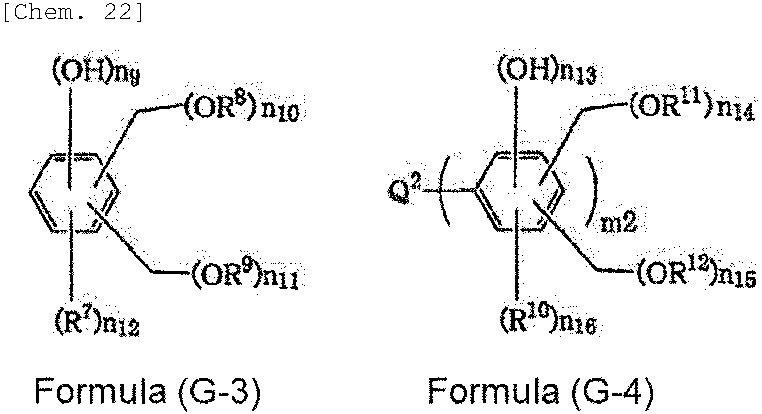
Formula (G-3)
Formula (G-4)
(In Formulas (G-3) and (G-4), Q² represents a single bond or an m2-valent organic group.

R⁸, R⁹, R¹¹, and R¹² each represent a hydrogen atom or a methyl group.

R⁷ and R¹⁰ each represent an alkyl group having 1 to 10 carbon atoms or an aryl group having 6 to 40 carbon atoms.

n₉ represents an integer that meets 1 ≤ n₉ ≤ 3, n₁₀ represents an integer that meets 2 ≤ n₁₀ ≤ 5, n₁₁ represents an integer that meets 0 ≤ n₁₁ ≤ 3, n₁₂ represents an integer that meets 0 ≤ n₁₂ ≤ 3, and an integer that meets 3 ≤ (n₉ + n₁₀ + n₁₁ + n₁₂) ≤ 6.

n₁₃ represents an integer that meets 1 ≤ n₁₃ ≤ 3, n₁₄ represents an integer that meets 1 ≤ n₁₄ ≤ 4, n₁₅ represents an integer that meets 0 ≤ n₁₅ ≤ 3, n₁₆ represents an integer that meets 0 ≤ n₁₆ ≤ 3, and an integer that meets 2 ≤ (n₁₃ + n₁₄ + n₁₅ + n₁₆) ≤ 5.

m2 represents an integer of 2 to 10)

Examples of the m2-valent organic group of Q² include an m2-valent organic group having 1 to 4 carbon atoms.

Examples of the compound represented by Formula (G-1) or (G-2) include the following compounds.

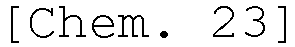

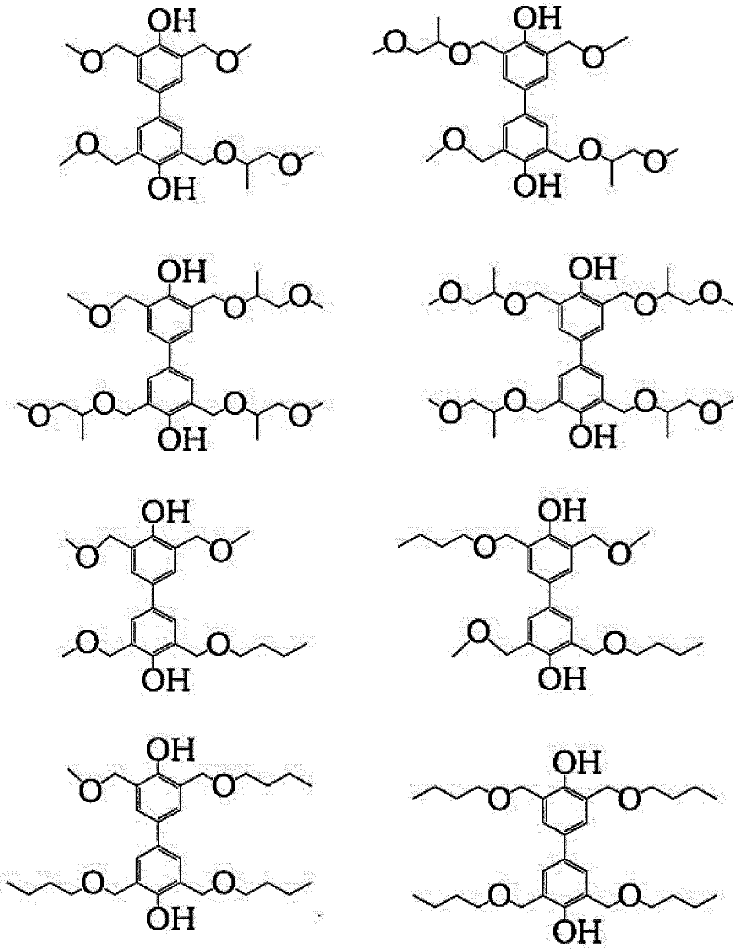

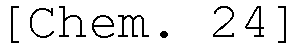

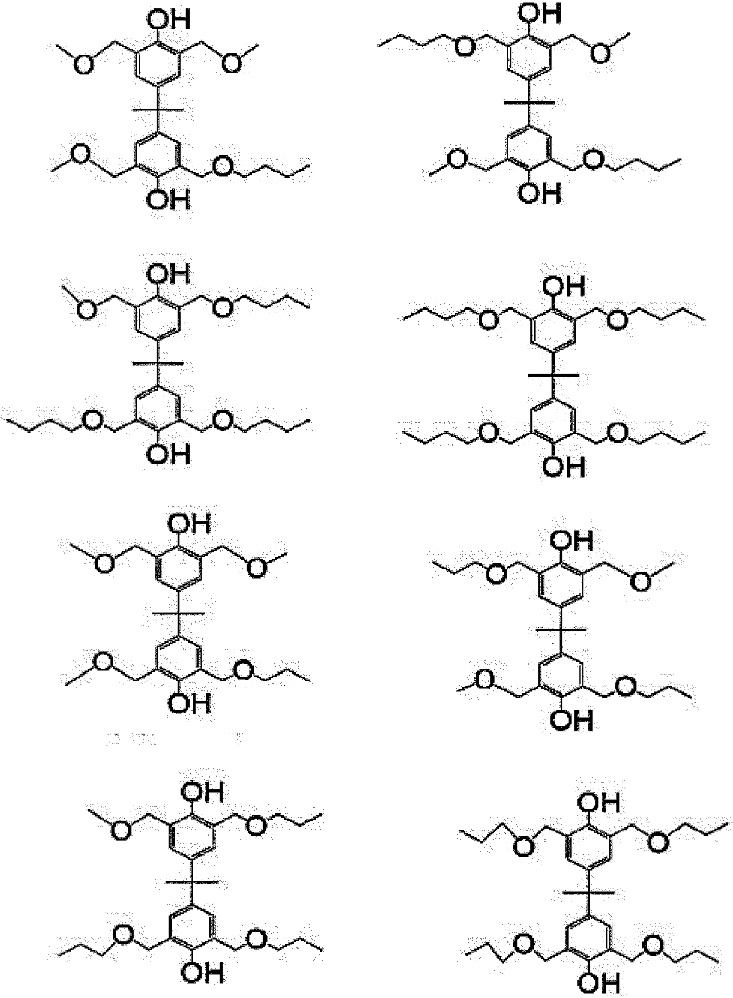

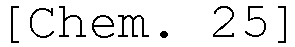

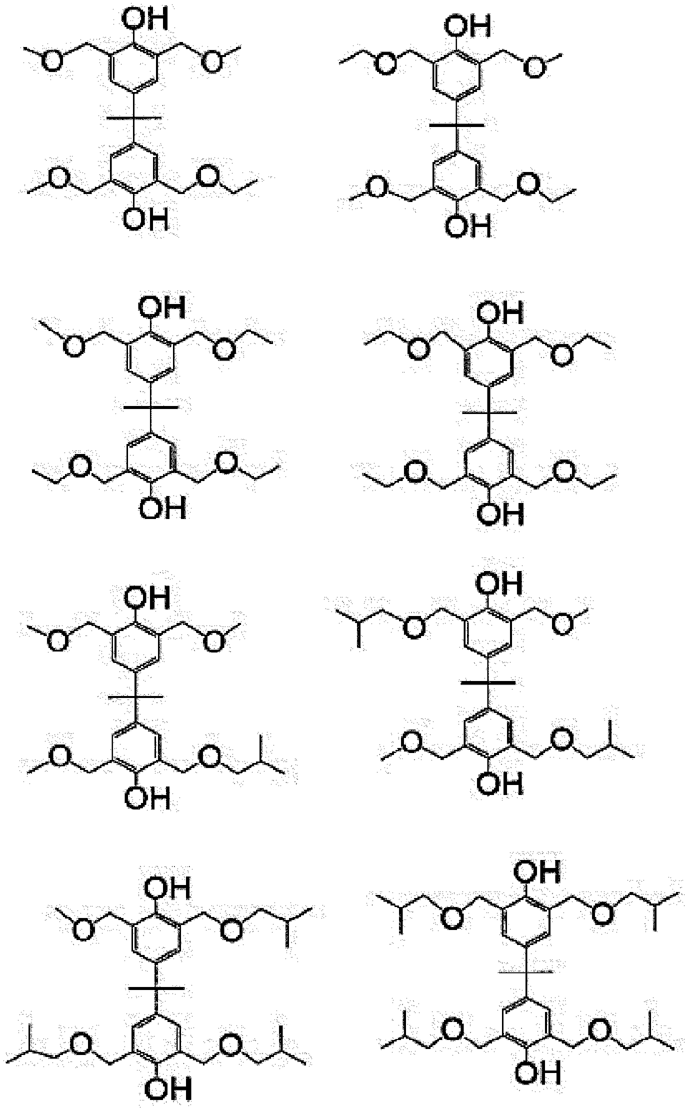

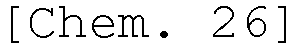

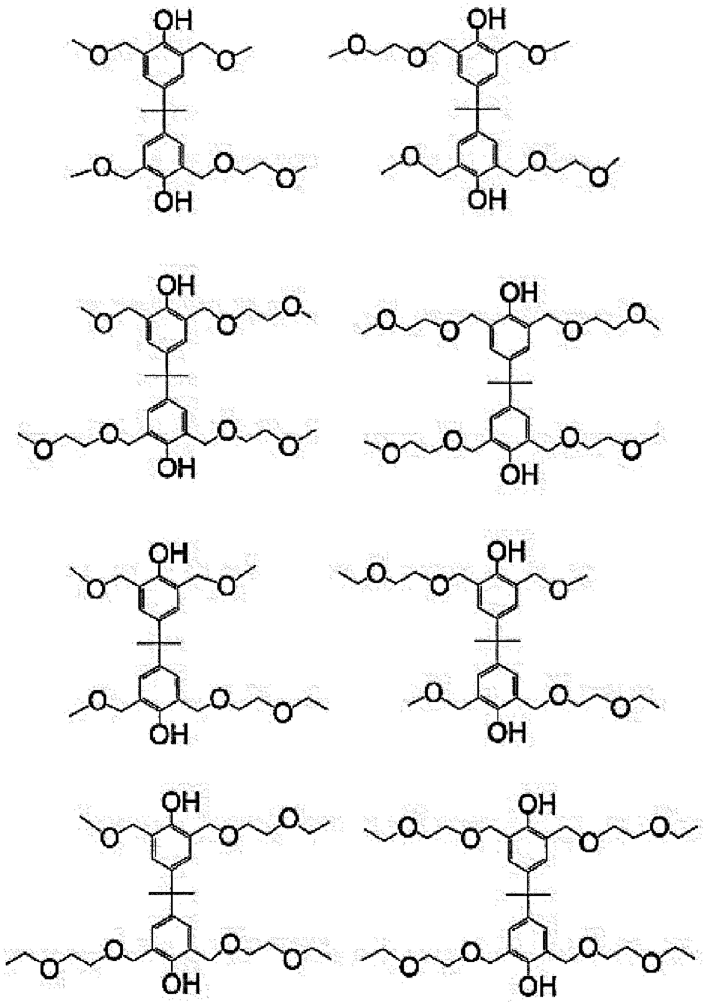

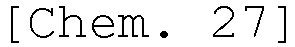

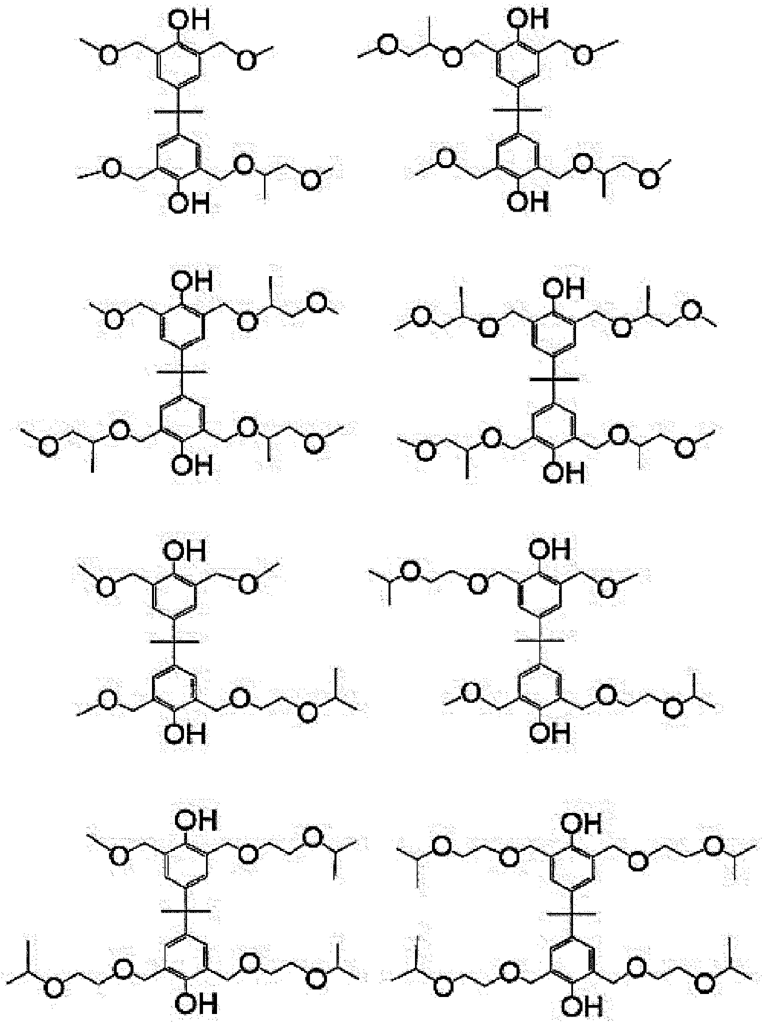

Examples of the compound represented by Formula (G-3) or (G-4) include the following compounds.

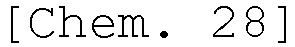

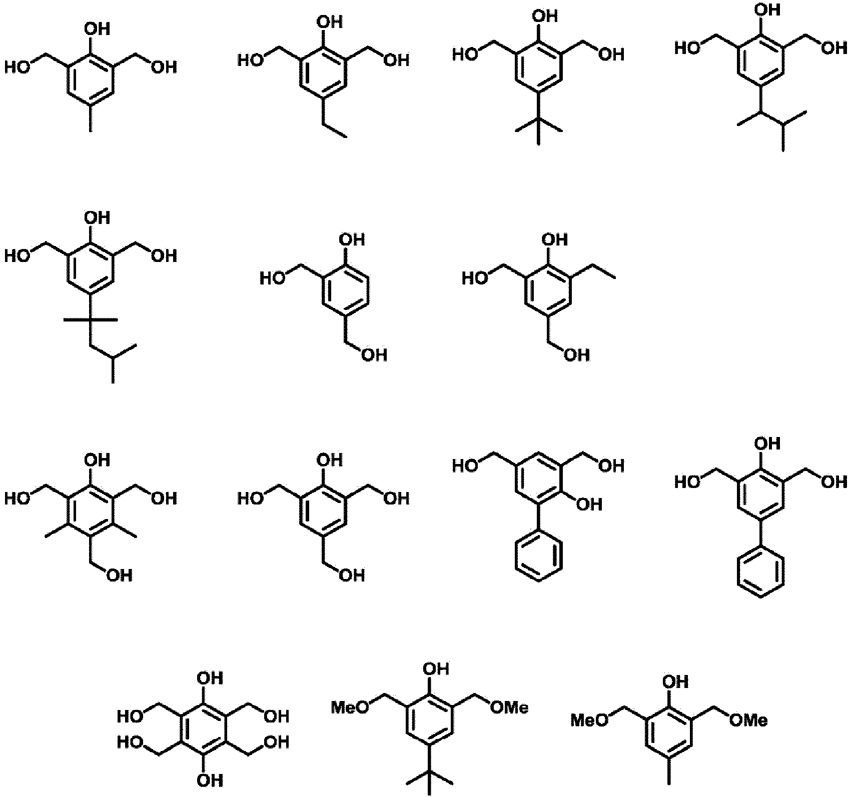

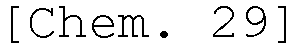

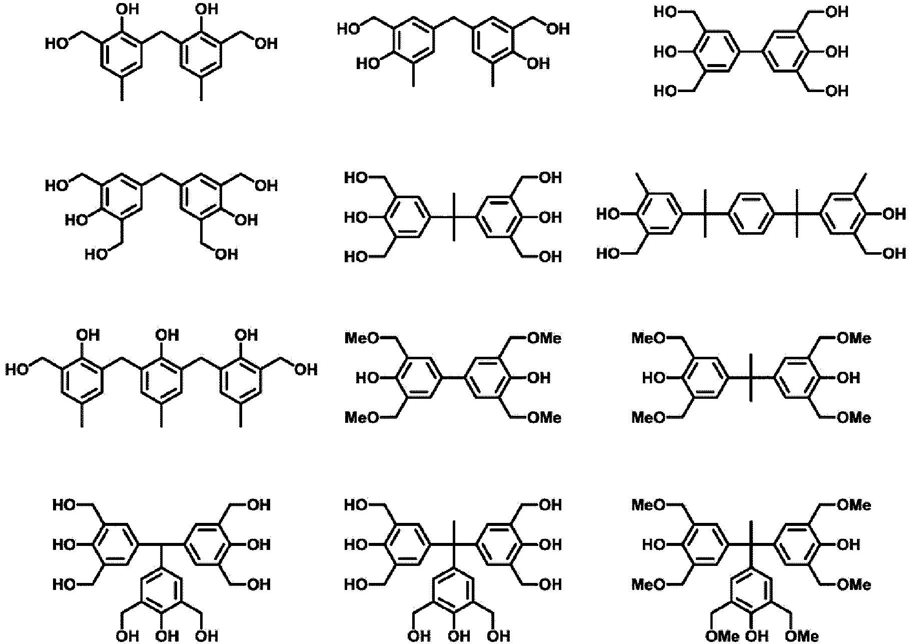

A product of Asahi Yukizai Corporation or Honshu Chemical Industry Co., Ltd. is available as the above compound. Examples of the product include TMOM-BP (trade name) of Asahi Yukizai Corporation.

Among the compounds, the glycoluril compound is preferable. Specifically, tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof are preferable, and tetramethoxymethyl glycoluril is more preferable.

The molecular weight of the crosslinking agent (C) is not particularly limited, and is preferably 500 or less.

The content of the crosslinking agent (C) in the resist underlayer film-forming composition is not particularly limited, and is, for example, 1 mass% to 70 mass%, and preferably 5 mass% to 60 mass% with respect to the novolac resin (A).

### <Curing Catalyst (D)>

As the curing catalyst (D) contained as an optional component in the resist underlayer film-forming composition, both a thermal acid generator and a photoacid generator can be used, and a thermal acid generator is preferably used.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenolsulfonate, pyridinium p-hydroxybenzenesulfonate (p-phenolsulfonic acid pyridinium salt), pyridinium-trifluoromethanesulfonate, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, hydroxybenzoic acid, N-methylmorpholine-p-toluenesulfonate, N-methylmorpholine-p-hydroxybenzenesulfonate, and N-methylmorpholine-5-sulfosalicylate.

Examples of the photoacid generator include an onium salt compound, a sulfonimide compound, and a disulfonyl diazomethane compound.

Examples of the onium salt compound include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compound include N-(trifluoromethanesulfonyloxy)succinimide, N-(nonafluoronormalbutanesulfonyloxy)succinimide, N-(camphorsulfonyloxy)succinimide, and N-(trifluoromethanesulfonyloxy)naphthalimide.

Examples of the disulfonyl diazomethane compound include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

Only one kind of the curing catalyst (D) can be used, or two or more kinds thereof can be used in combination.

In a case where the curing catalyst (D) is used, the content ratio of the curing catalyst (D) is, for example, 0.1 mass% to 50 mass%, and preferably 1 mass% to 30 mass% with respect to the crosslinking agent (C).

### <Other Components>

A surfactant can be further added to the resist underlayer film-forming composition in order to further improve the coatability against surface unevenness without formation of pinholes, striations, or the like.

Examples of the surfactant include nonionic surfactants including polyoxyethylene alkyl ethers such as polyoxyethylene lauryl ether, polyoxyethylene stearyl ether, polyoxyethylene cetyl ether, and polyoxyethylene oleyl ether, polyoxyethylene alkyl allyl ethers such as polyoxyethylene octylphenol ether and polyoxyethylene nonylphenol ether, polyoxyethylene-polyoxypropylene block copolymers, sorbitan fatty acid esters such as sorbitan monolaurate, sorbitan monopalmitate, sorbitan monostearate, sorbitan monooleate, sorbitan trioleate, and sorbitan tristearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, fluorine-based surfactants such as EFTOP EF301, EF303, and EF352 (trade name, manufactured by Tochem Products Co., Ltd.), MEGAFAC F171, F173, and R-30 (trade name, manufactured by DIC Corporation), Fluorad FC430 and FC431 (trade name, manufactured by Sumitomo 3M Limited), Asahi Guard AG710, Surflon S-382, SC101, SC102, SC103, SC104, SC105, and SC106 (trade name, manufactured by AGC Corporation), and an organosiloxane polymer KP341 (manufactured by Shin-Etsu Chemical Co., Ltd.).

The blending amount of such a surfactant is usually 2.0 mass% or less, and preferably 1.0 mass% or less with respect to the total solid content of the resist underlayer film-forming composition.

These surfactants may be added alone or in combination of two or more thereof.

The amount of the solid content in the resist underlayer film-forming composition of the present invention, that is, the components excluding the solvent is, for example, 0.01 mass% to 10 mass%.

The resist underlayer film-forming composition of the present invention is preferably a resist underlayer film-forming composition for extreme ultraviolet (EUV) or electron beam lithography.

### (Resist Underlayer Film)

A resist underlayer of the present invention is a cured product of the above-described resist underlayer film-forming composition.

The resist underlayer film can be produced by, for example, applying the above-described resist underlayer film-forming composition onto a semiconductor substrate and baking the composition.

Examples of the semiconductor substrate to which the resist underlayer film-forming composition is applied include a silicon wafer, a germanium wafer, and a compound semiconductor wafer of gallium arsenide, indium phosphide, gallium nitride, indium nitride, aluminum nitride, or the like.

When a semiconductor substrate having an inorganic film formed on a surface thereof is used, the inorganic film is formed by, for example, an atomic layer deposition (ALD) method, a chemical vapor deposition (CVD) method, a reactive sputtering method, an ion plating method, a vacuum deposition method, or a spin coating method (spin-on glass: SOG). Examples of the inorganic film include a polysilicon film, a silicon oxide film, a silicon nitride film, a borophospho silicate glass (BPSG) film, a titanium nitride film, a titanium nitride oxide film, a tungsten film, a gallium nitride film, and a gallium arsenide film.

The resist underlayer film-forming composition of the present invention is applied onto such a semiconductor substrate by an appropriate application method such as a spinner or a coater. Thereafter, baking is performed using heating means such as a hot plate to form a resist underlayer film. The baking conditions are appropriately selected from a baking temperature of 100°C to 400°C and a baking time of 0.3 minutes to 60 minutes. Preferably, the baking temperature is 120°C to 350°C and the baking time is 0.5 minutes to 30 minutes. More preferably, the baking temperature is 150°C to 300°C and the baking time is 0.8 minutes to 10 minutes.

The film thickness of the resist underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), or 0.005 µm (5 nm).

The film thickness of the resist underlayer film is preferably 2 nm to 20 nm from the viewpoint of suitably obtaining the effects of the present invention.

In the present specification, the method of measuring the film thickness of the resist underlayer film is as follows.
· Measurement device name: Ellipsometric film thickness measurement device RE-3100 (SCREEN Holdings Co., Ltd.)
· Single wavelength ellipsometer (SWE) mode
· Arithmetic average of measurements at 8 points (for example, measurement is made at 8 points at intervals of 1 cm in X direction of wafer)

### (Laminate)

A laminate of the present invention includes a semiconductor substrate and the resist underlayer film of the present invention.

Examples of the semiconductor substrate include the semiconductor substrates described above.

The resist underlayer film is disposed on the semiconductor substrate, for example.

### (Semiconductor Element Producing Method and Pattern Forming Method)

A semiconductor element producing method of the present invention includes at least the following steps.
· A step of forming a resist underlayer film on a semiconductor substrate using the resist underlayer film-forming composition of the present invention, and
· A step of forming a resist film on the resist underlayer film

A pattern forming method of the present invention includes at least the following steps.
· A step of forming a resist underlayer film on a semiconductor substrate using the resist underlayer film-forming composition of the present invention,
· A step of forming a resist film on the resist underlayer film,
· A step of irradiating the resist film with light or electron beams, and then developing the resist film to obtain a resist pattern, and
· A step of etching the resist underlayer film using the resist pattern as a mask

Usually, a resist layer is formed on the resist underlayer film.

The film thickness of the resist layer is, for example, 3,000 nm or less, 2,000 nm or less, 1,800 nm or less, 1,500 nm or less, or 1,000 nm or less. The lower limit is 100 nm, 80 nm, 50 nm, 30 nm, 20 nm, or 10 nm.

The resist film formed on the resist underlayer film by a known method (such as application and baking of a resist composition) is not particularly limited as long as it responds to light or an electron beam (EB) used for irradiation. Both a negative photoresist and a positive photoresist can be used.

In the present specification, a resist responding to EB is also referred to as a photoresist.

Examples of the photoresist include a positive photoresist including a novolac resin and **1,2-**naphthoquinone diazide sulfonic acid ester, a chemically amplified photoresist including a binder having a group which is decomposed by an acid to increase an alkali dissolution rate and a photoacid generator, a chemically amplified photoresist including a low-molecular compound which is decomposed by an acid to increase an alkali dissolution rate of the photoresist, an alkali-soluble binder, and a photoacid generator, a chemically amplified photoresist including a binder having a group which is decomposed by an acid to increase an alkali dissolution rate, a low-molecular compound which is decomposed by an acid to increase an alkali dissolution rate of the photoresist, and a photoacid generator, and a resist containing a metal element. Examples thereof include trade name V146G manufactured by JSR Corporation, trade name APEX-E manufactured by Shipley, trade name PAR710 manufactured by Sumitomo Chemical Co., Ltd., and trade names AR2772 and SEPR430 manufactured by Shin-Etsu Chemical Co., Ltd. In addition, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

Furthermore, so-called resist compositions and metal-containing resist compositions can be used which include resist compositions, radiation-sensitive resin compositions, and high-resolution patterning compositions based on organometallic solutions, described in WO 2019/188595, WO 2019/187881, WO 2019/187803, WO 2019/167737, WO 2019/167725, WO 2019/187445, WO 2019/167419, WO 2019/123842, WO 2019/054282, WO 2019/058945, WO 2019/058890, WO 2019/039290, WO 2019/044259, WO 2019/044231, WO 2019/026549, WO 2018/193954, WO 2019/172054, WO 2019/021975, WO 2018/230334, WO 2018/194123, JP 2018-180525, WO 2018/190088, JP 2018-070596, JP 2018-028090, JP 2016-153409, JP 2016-130240, JP 2016-108325, JP 2016-047920, JP 2016-035570, JP 2016-035567, JP 2016-035565, JP 2019-101417, JP 2019-117373, JP 2019-052294, JP 2019-008280, JP 2019-008279, JP 2019-003176, JP 2019-003175, JP 2018-197853, JP 2019-191298, JP 2019-061217, JP 2018-045152, JP 2018-022039, JP 2016-090441, JP 2015-10878, JP 2012-168279, JP 2012-022261, JP 2012-022258, JP 2011-043749, JP 2010-181857, JP 2010-128369, WO 2018/031896, JP 2019-113855, WO 2017/156388, WO 2017/066319, JP 2018-41099, WO 2016/065120, WO 2015/026482, JP 2016-29498, JP 2011-253185, and the like, but the resist compositions are not limited thereto.

Examples of the resist composition include the following compositions.

An active ray-sensitive or radiation-sensitive resin composition including: a resin A having a repeating unit having an acid-decomposable group in which a polar group is protected by a protecting group which is desorbed by the action of an acid; and a compound represented by General Formula (121) shown below. 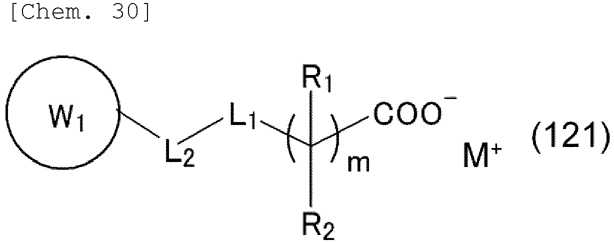 In General Formula (121), m represents an integer of 1 to 6.

R₁ and R₂ each independently represent a fluorine atom or a perfluoroalkyl group.

L₁ represents -O-, -S-, -COO-, -SO₂-, or -SO₃-.

L₂ represents an alkylene group which may have a substituent or a single bond.

W₁ represents a cyclic organic group which may have a substituent.

M⁺ represents a cation.

A metal-containing film-forming composition for extreme ultraviolet or electron beam lithography, containing a compound having a metal-oxygen covalent bond and a solvent, in which metal elements constituting the compound belong to periods 3 to 7 of groups 3 to 15 of the periodic table.

A radiation-sensitive resin composition containing a polymer having a first structural unit represented by Formula (31) shown below and a second structural unit containing an acid-dissociable group represented by Formula (32) shown below, and an acid generator. 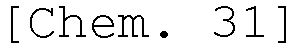 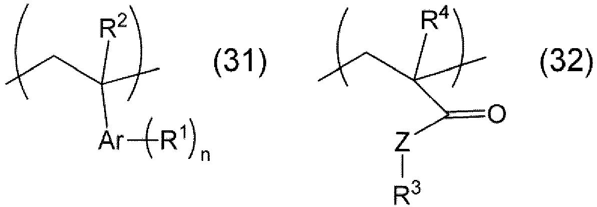 (In Formula (31), Ar is a group in which (n + 1) hydrogen atoms are removed from an arene having 6 to 20 carbon atoms. R¹ is a hydroxy group, a sulfanyl group, or a monovalent organic group having 1 to 20 carbon atoms. n is an integer of 0 to 11. When n is 2 or more, a plurality of R¹'s are the same or different. R² is a hydrogen atom, a fluorine atom, a methyl group, or a trifluoromethyl group. In Formula (32), R³ is a monovalent group having 1 to 20 carbon atoms and including the acid-dissociable group. Z is a single bond, an oxygen atom, or a sulfur atom. R⁴ is a hydrogen atom, a fluorine atom, a methyl group, or a trifluoromethyl group)

A resist composition containing: a resin (A1) including a structural unit having a cyclic carbonate ester structure, a structural unit represented by a formula shown below, and a structural unit having an acid unstable group; and an acid generator. 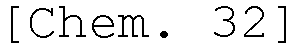 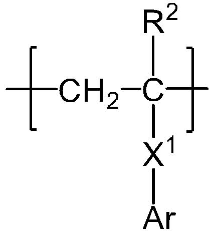 [In the formula,
R² represents an alkyl group having 1 to 6 carbon atoms which may have a halogen atom, a hydrogen atom, or a halogen atom, X¹ represents a single bond, -CO-O-*, or -CO-NR⁴-*, where * represents a bond with -Ar, R⁴ represents a hydrogen atom or an alkyl group having 1 to 4 carbon atoms, and Ar represents an aromatic hydrocarbon group having 6 to 20 carbon atoms which may have one or more groups selected from the group consisting of a hydroxy group and a carboxyl group.]

Examples of the resist film are as follows.

A resist film including a base resin including a repeating unit represented by Formula (a1) shown below and/or a repeating unit represented by Formula (a2) shown below, and a repeating unit which generates an acid bonded to a polymer main chain by exposure. 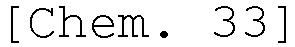 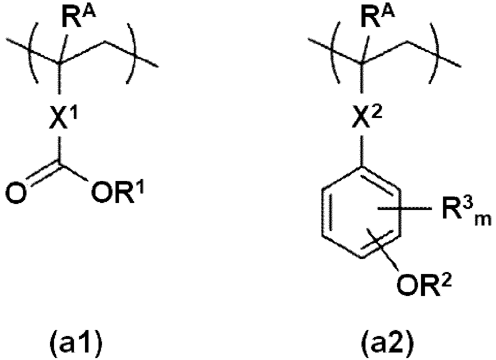 (In Formulas (a1) and (a2), R^{A}'s each independently are a hydrogen atom or a methyl group. R¹ and R² each independently are a tertiary alkyl group having 4 to 6 carbon atoms. R³'s each independently are a fluorine atom or a methyl group. m is an integer of 0 to 4. X¹ is a single bond, a phenylene group, a naphthylene group, or a linking group having 1 to 12 carbon atoms and including at least one selected from an ester bond, a lactone ring, a phenylene group, and a naphthylene group. X² is a single bond, an ester bond, or an amide bond)

Examples of the resist material are as follows.

A resist material including a polymer having a repeating unit represented by Formula (b1) or (b2) shown below.

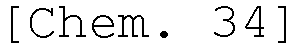

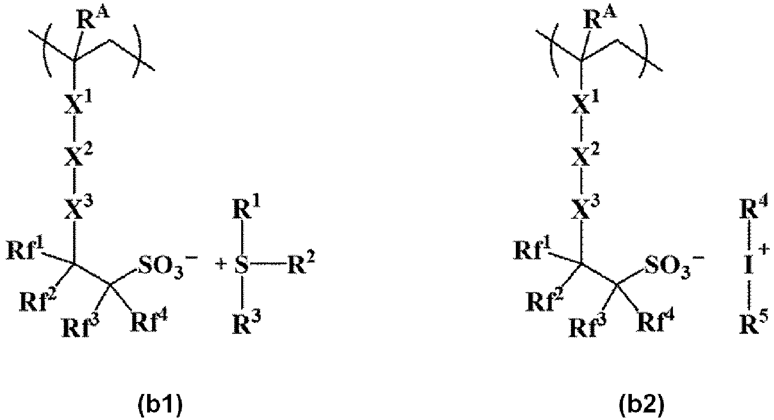

(In Formulas (b1) and (b2), R^{A} is a hydrogen atom or a methyl group. X¹ is a single bond or an ester group. X² is a linear, branched, or cyclic alkylene group having 1 to 12 carbon atoms or an arylene group having 6 to 10 carbon atoms, in which some of methylene groups constituting the alkylene group may be substituted with an ether group, an ester group, or a lactone ring-containing group, and at least one hydrogen atom included in X² is substituted with a bromine atom. X³ is a single bond, an ether group, an ester group, or a linear, branched, or cyclic alkylene group having 1 to 12 carbon atoms, in which some of methylene groups constituting the alkylene group may be substituted with an ether group or an ester group. Rf¹ to Rf⁴ each independently are a hydrogen atom, a fluorine atom, or a trifluoromethyl group; however, at least one of them is a fluorine atom or a trifluoromethyl group. In addition, Rf¹ and Rf² may also be combined to form a carbonyl group. R¹ to R⁵ each independently are a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, some or all of hydrogen atoms of these groups may be substituted with a hydroxy group, a carboxy group, a halogen atom, an oxo group, a cyano group, an amide group, a nitro group, a sultone group, a sulfone group, or a sulfonium salt-containing group, and some of methylene groups constituting these groups may be substituted with an ether group, an ester group, a carbonyl group, a carbonate group, or a sulfonic acid ester group. R¹ and R² may be bonded to form a ring together with a sulfur atom to which R¹ and R² are bonded)

A resist material including a base resin including a polymer having a repeating unit represented by Formula (a) shown below. 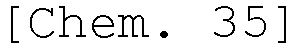 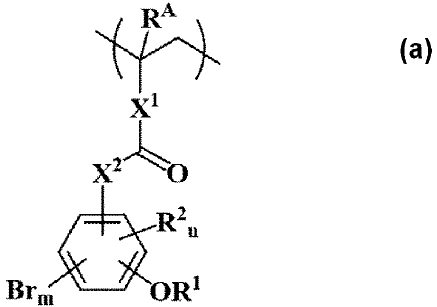 (In Formula (a), R^{A} is a hydrogen atom or a methyl group. R¹ is a hydrogen atom or an acid unstable group. R² is a linear, branched, or cyclic alkyl group having 1 to 6 carbon atoms or a halogen atom other than bromine. X¹ is a single bond, a phenylene group, or a linear, branched, or cyclic alkylene group having 1 to 12 carbon atoms which may include an ester group or a lactone ring. X² is -O-, -O-CH₂-, or -NH-. m is an integer of 1 to 4. u is an integer of 0 to 3. m + u is an integer of 1 to 4)

A resist composition which generates an acid by exposure and whose solubility in a developer is changed by the action of an acid, the resist composition containing:
a base material component (A) whose solubility in the developer is changed by the action of an acid; and a fluorine additive component (F) which is decomposable in an alkaline developer,
in which the fluorine additive component (F) contains a fluororesin component (F1) having a structural unit (f1) containing a base-dissociable group and a structural unit (f2) containing a group represented by General Formula (f2-r-1) shown below. 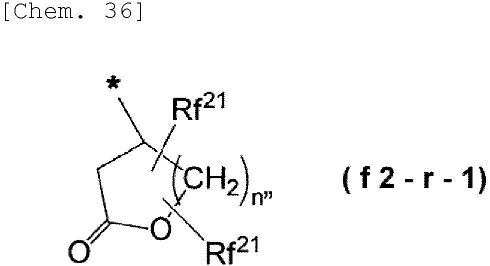
[In Formula (f2-r-1), Rf²¹'s each independently are a hydrogen atom, an alkyl group, an alkoxy group, a hydroxy group, a hydroxyalkyl group, or a cyano group. n" is an integer of 0 to 2. * is a bond.]

The structural unit (f1) includes a structural unit represented by General Formula (f1-1) shown below or a structural unit represented by General Formula (f1-2) shown below. 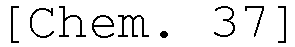 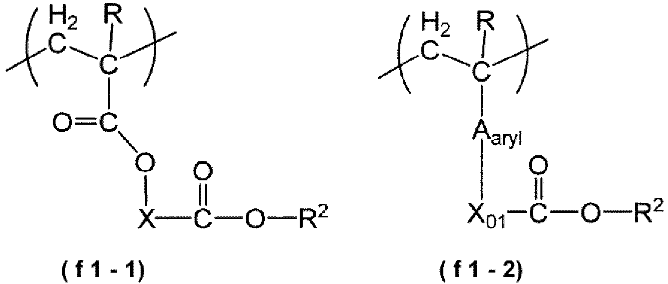 [In Formulas (f1-1) and (f1-2), R's each independently are a hydrogen atom, an alkyl group having 1 to 5 carbon atoms, or a halogenated alkyl group having 1 to 5 carbon atoms. X is a divalent linking group having no acid-dissociable moiety. A_{aryl} is a divalent aromatic cyclic group which may have a substituent. X₀₁ is a single bond or a divalent linking group. R²'s each independently are an organic group having a fluorine atom.]

Examples of the coating, the coating solution, and the coating composition are as follows.

A coating including a metal oxo-hydroxo network having an organic ligand via a metal carbon bond and/or a metal carboxylate bond.

An inorganic oxo/hydroxo-based composition.

A coating solution including: an organic solvent; a first organometallic composition represented by Formula R_{z}SnO_{(2-(z/2)-(x/2))}(OH)ₓ (where 0 < z ≤ 2 and 0 < (z + x) ≤ 4), Formula R'ₙSnX₄₋ₙ (where n = 1 or 2) or a mixture thereof, where R and R' are independently a hydrocarbyl group having 1 to 31 carbon atoms, and X is a ligand having a hydrolyzable bond to Sn or a combination thereof; and a hydrolyzable metal compound represented by Formula MX'ᵥ (where M is a metal selected from groups 2 to 16 of the periodic table of the elements, v = 2 to 6, and X' is a ligand having a hydrolyzable M-X bond or a combination thereof).

A coating solution including an organic solvent and a first organometallic compound represented by Formula RSnO_{(3/2-x/2)}(OH)ₓ (where 0 < x < 3), in which the solution contains about 0.0025 M to 1.5 M of tin, R is an alkyl group or a cycloalkyl group having 3 to 31 carbon atoms, and the alkyl group or the cycloalkyl group is bonded to tin at a secondary or tertiary carbon atom.

An inorganic pattern forming precursor aqueous solution including a mixture of water, a metal suboxide cation, a polyatomic inorganic anion, and a radiation-sensitive ligand containing a peroxide group.

Irradiation with light or electron beams is performed, for example, through a mask (reticle) for forming a predetermined pattern. For example, i-rays, a KrF excimer laser, an ArF excimer laser, extreme ultraviolet rays (EUV), or electron beams (EB) are used. The resist underlayer film-forming composition of the present invention is preferably applied for electron beam (EB) or extreme ultraviolet (EUV: 13.5 nm) irradiation, and more preferably applied for extreme ultraviolet (EUV) exposure.

The electron beam irradiation energy and the light exposure are not particularly limited.

Baking (PEB: post exposure bake) may be performed after light or electron beam irradiation and before development.

The baking temperature is not particularly limited, and is preferably 60°C to 150°C, more preferably 70°C to 120°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

For the development, for example, an alkaline developer is used.

The development temperature is, for example, 5°C to 50°C.

The development time is, for example, 10 seconds to 300 seconds.

As the alkaline developer, it is possible to use, for example, aqueous solutions of alkalies, such as inorganic alkalies such as sodium hydroxide, potassium hydroxide, sodium carbonate, sodium silicate, sodium metasilicate, and aqueous ammonia, primary amines such as ethylamine and n-propylamine, secondary amines such as diethylamine and din-butylamine, tertiary amines such as triethylamine and methyldiethylamine, alcohol amines such as dimethylethanolamine and triethanolamine, quaternary ammonium salts such as tetramethylammonium hydroxide, tetraethylammonium hydroxide, and choline, and cyclic amines such as pyrrole and piperidine. It is also possible to use the above-described aqueous solutions of alkalies, to which alcohols such as isopropyl alcohol or surfactants such as nonionic surfactants are added in an appropriate amount. Of these, preferable developers are an aqueous solution of a quaternary ammonium salt, and more preferably an aqueous solution of tetramethylammonium hydroxide and an aqueous solution of choline. Furthermore, a surfactant or the like can be added to these developers. Instead of the alkali developer, a method of performing development with an organic solvent such as butyl acetate and developing a portion where an alkali dissolution rate of the photoresist is not increased can also be used.

Next, the resist underlayer film is etched using the formed resist pattern as a mask. The etching may be dry etching or wet etching, and is preferably dry etching.

In a case where the inorganic film is formed on the surface of the semiconductor substrate used, the surface of the inorganic film is exposed; and in a case where the inorganic film is not formed on the surface of the semiconductor substrate used, the surface of the semiconductor substrate is exposed. Then, a semiconductor element can be produced through a step of processing the semiconductor substrate with a known method (dry etching method or the like).

### Examples

Next, the content of the present invention will be specifically described with reference to synthesis examples and examples, but the present invention is not limited thereto.

The weight average molecular weights of polymers shown in Synthesis Examples 1 to 4 and Comparative Synthesis Example 1 shown below are results of measurement by gel permeation chromatography (hereinafter, abbreviated as GPC). For the measurement, a GPC device manufactured by Tosoh Corporation was used, and measurement conditions and the like are as follows.
· GPC column: Shodex GF-710HQ, Shodex GF-510HQ, Shodex GF-310HQ [registered trademark] (Showa Denko K.K.)
· Column temperature: 40°C
· Flow rate: 0.6 ml/min
· Eluent: N,N-dimethylformamide (DMF)
· Standard sample: polystyrene (Tosoh Corporation)

### <Synthesis Example 1>

3.00 g of phloroglucinol (manufactured by Tokyo Chemical Industry Co., Ltd.), 6.61 g of 3,5-dibromo-4-hydroxybenzaldehyde (manufactured by Tokyo Chemical Industry Co., Ltd.), and 0.04 g of p-toluenesulfonic acid (manufactured by Midori Kagaku Co., Ltd.) were added and dissolved in 22.5 g of propylene glycol monomethyl ether in a reaction vessel. The reaction vessel was purged with nitrogen, and then the reaction was performed at 90°C for 24 hours to prepare a polymer solution. The polymer solution does not cause cloudiness or other appearance change even when cooled to room temperature, and had good solubility in propylene glycol monomethyl ether. GPC analysis was performed, and the polymer in the obtained solution had a weight average molecular weight of 3,000 as determined by standard polystyrene conversion. The polymer obtained in the present Synthesis Example has structural units represented by Formulas (1a) and (1b) shown below.

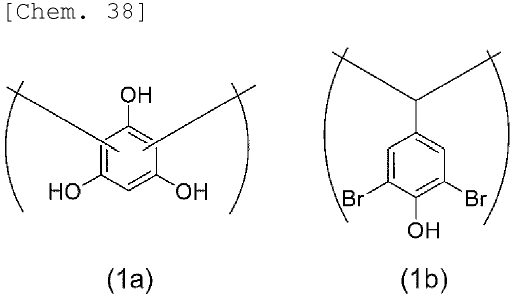

### <Synthesis Example 2>

2.00 g of phloroglucinol (manufactured by Tokyo Chemical Industry Co., Ltd.), 4.19 g of 3,5-dibromobenzaldehyde (manufactured by Tokyo Chemical Industry Co., Ltd.), and 0.03 g of p-toluenesulfonic acid (manufactured by Midori Kagaku Co., Ltd.) were added and dissolved in 14.5 g of propylene glycol monomethyl ether in a reaction vessel. The reaction vessel was purged with nitrogen, and then the reaction was performed at 90°C for 24 hours to prepare a polymer solution. The polymer solution does not cause cloudiness or other appearance change even when cooled to room temperature, and had good solubility in propylene glycol monomethyl ether. GPC analysis was performed, and the polymer in the obtained solution had a weight average molecular weight of 3,000 as determined by standard polystyrene conversion. The polymer obtained in the present Synthesis Example has structural units represented by Formulas (1a) and (2b) shown below.

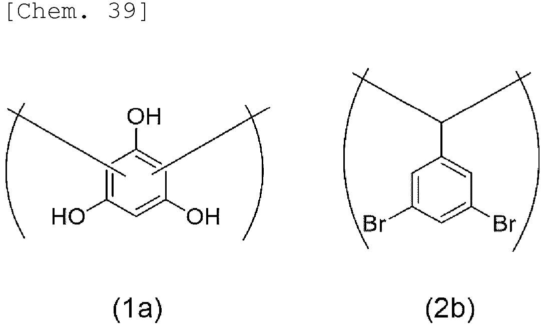

### <Synthesis Example 3>

2.00 g of 2,6-dimethyl hydroquinone (manufactured by Tokyo Chemical Industry Co., Ltd.), 3.82 g of 3,5-dibromobenzaldehyde (manufactured by Tokyo Chemical Industry Co., Ltd.), and 0.12 g of p-toluenesulfonic acid (manufactured by Midori Kagaku Co., Ltd.) were added and dissolved in 13.9 g of propylene glycol monomethyl ether in a reaction vessel. The reaction vessel was purged with nitrogen, and then the reaction was performed at 90°C for 24 hours to prepare a polymer solution. The polymer solution does not cause cloudiness or other appearance change even when cooled to room temperature, and had good solubility in propylene glycol monomethyl ether. GPC analysis was performed, and the polymer in the obtained solution had a weight average molecular weight of 1,000 as determined by standard polystyrene conversion. The polymer obtained in the present Synthesis Example has structural units represented by Formulas (2a) and (2b) shown below.

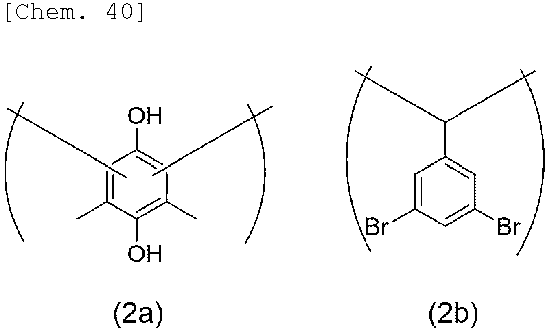

### <Synthesis Example 4>

3.00 g of phloroglucinol (manufactured by Tokyo Chemical Industry Co., Ltd.), 8.90 g of 3,5-diiodo-4-hydroxybenzaldehyde (manufactured by Tokyo Chemical Industry Co., Ltd.), and 0.05 g of p-toluenesulfonic acid (manufactured by Midori Kagaku Co., Ltd.) were added and dissolved in 27.9 g of propylene glycol monomethyl ether in a reaction vessel. The reaction vessel was purged with nitrogen, and then the reaction was performed at 90°C for 24 hours to prepare a polymer solution. The polymer solution does not cause cloudiness or other appearance change even when cooled to room temperature, and had good solubility in propylene glycol monomethyl ether. GPC analysis was performed, and the polymer in the obtained solution had a weight average molecular weight of 9,000 as determined by standard polystyrene conversion. The polymer obtained in the present Synthesis Example has structural units represented by Formulas (1a) and (4b) shown below.

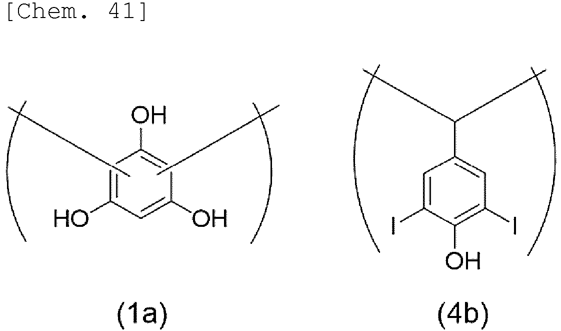

### <Comparative Synthesis Example 1>

5.00 g of phloroglucinol (manufactured by Tokyo Chemical Industry Co., Ltd.) and 4.21 g of benzaldehyde (manufactured by Tokyo Chemical Industry Co., Ltd.) were added and dissolved in 22.5 g of propylene glycol monomethyl ether in a reaction vessel. The reaction vessel was purged with nitrogen, and then the reaction was performed at 90°C for 24 hours to prepare a polymer solution. The polymer solution does not cause cloudiness or other appearance change even when cooled to room temperature, and had good solubility in propylene glycol monomethyl ether. GPC analysis was performed, and the polymer in the obtained solution had a weight average molecular weight of 4,000 as determined by standard polystyrene conversion. The polymer obtained in the present Synthesis Example has structural units represented by Formulas (1a) and (3b) shown below.

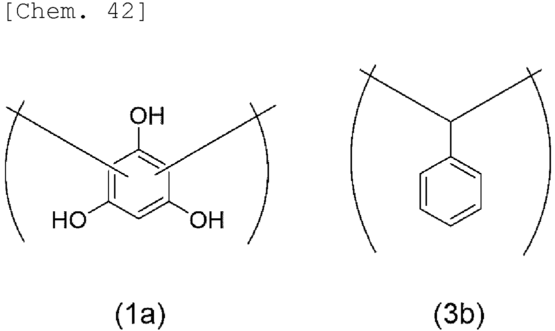

### (Examples and Comparative Examples)

Each of the polymers obtained in Synthesis Examples 1 to 4 and Comparative Synthesis Example 1 shown above, a crosslinking agent, a curing catalyst, and a solvent were mixed in the proportion shown in Table 1, and the mixture was filtered through a 0.1 µm fluororesin filter to prepare each resist underlayer film-forming composition. The amount of each additive was expressed by parts by mass, and the solvent was expressed by a composition ratio.

Abbreviations in Table 1 are as follows.
· PL: tetramethoxymethyl glycoluril
· Py-PSA: pyridinium-p-hydroxybenzenesulfonate
· PGMEA: propylene glycol monomethyl ether acetate
· PGME: propylene glycol monomethyl ether

**[Table 1]**

| | | Polymer | Crosslinking Agent | Curing Catalyst | Solvent Composition | |
|---|---|---|---|---|---|---|
| Example 1 | Kind | Synthesis Example 1 | PL | Py-PSA | PGME | PGMEA |
| | (Parts by mass) | 0.157 | 0.039 | 0.004 | 88.97 | 9.98 |
| Example 2 | Kind | Synthesis Example 2 | PL | Py-PSA | PGME | PGMEA |
| | (Parts by mass) | 0.157 | 0.039 | 0.004 | 88.97 | 9.98 |
| Example 3 | Kind | Synthesis Example 3 | PL | Py-PSA | PGME | PGMEA |
| | (Parts by mass) | 0.157 | 0.039 | 0.004 | 88.97 | 9.98 |
| Example 4 | Kind | Synthesis Example 4 | PL | Py-PSA | PGME | PGMEA |
| | (Parts by mass) | 0.157 | 0.039 | 0.004 | 88.97 | 9.98 |
| Comparative Example 1 | Kind | Comparative Synthesis Example 1 | PL | Py-PSA | PGME | PGMEA |
| | (Parts by mass) | 0.157 | 0.039 | 0.004 | 88.97 | 9.98 |

### (Elution Test in Photoresist Solvent)

Each of the resist underlayer film-forming compositions of Examples 1 to 4 and Comparative Example 1 was applied onto a silicon wafer using a spinner. The silicon wafer was baked at 205°C for 60 seconds on a hot plate to obtain a resist underlayer film having a film thickness of 5 nm. These resist underlayer films were immersed in a mixed solution of propylene glycol monomethyl ether acetate/propylene glycol monomethyl ether = 70/30 (mass ratio), which is a solvent used for the photoresist. A case where the film thickness change was 5 Å or less was evaluated as "good", and a case where the film thickness change was 5 Å or more was evaluated as "poor". The results are shown in Table 2.

**[Table 2]**

| | Elution Test |
|---|---|
| Example 1 | Good |
| Example 2 | Good |
| Example 3 | Good |
| Example 4 | Good |
| Comparative Example 1 | Good |

### (Evaluation of Resist Patterning)

### [Test of Resist Pattern Formation by Electron Beam Lithography Device]

Each of the resist underlayer film-forming compositions of Examples 1, 2, and 4 and Comparative Example 1 was applied onto a silicon wafer using a spinner. The silicon wafer was baked at 205°C for 60 seconds on a hot plate to obtain a resist underlayer film having a film thickness of 5 nm. A positive resist solution for EUV was applied onto the resist underlayer film by spin coating and heated at 130°C for 60 seconds to form an EUV resist film. The resist film was exposed under predetermined conditions using an electron beam lithography device (ELS-G130). After the exposure, the silicon wafer was baked (PEB) at 100°C for 60 seconds, cooled on a cooling plate to room temperature, and subjected to puddle developing for 30 seconds using a 2.38% aqueous tetramethylammonium hydroxide solution (trade name NMD-3 manufactured by Tokyo Ohka Kogyo Co., Ltd.) as a photoresist developer. A resist pattern having a hole size of 16 nm to 26 nm was formed. A scanning electron microscope (CG4100 manufactured by Hitachi High-Technologies Corporation) was used to measure the length of the resist pattern.

With respect to the photoresist pattern thus obtained, whether a contact hole (C/H) of 23 nm could be formed was checked for evaluation. In Examples 1 and 2 having a halogen atom, 23 nm C/H pattern formation was observed. The charge amount at which the 23 nm contact hole is formed is defined as optimum irradiation energy, and the irradiation energy (µC/cm²) when the irradiation energy of Comparative Example 1 is set to 1.00 is shown in Table 3. In Examples 1, 2, and 4, a reduction in optimum irradiation energy as compared with Comparative Example 1 was observed.

**[Table 3]**

| | Optimum Irradiation Energy (Comparison with Comparative Example 1 (1.00)) |
|---|---|
| Example 1 | 0.93 |
| Example 2 | 0.98 |
| Example 4 | 0.95 |
| Comparative Example 1 | 1.00 |

### (Measurement of Etching Rate)

Using each of the resist underlayer film-forming compositions prepared in Examples 1 to 4 and Comparative Example 1, a resist underlayer film having a film thickness of 5 nm was formed on a silicon wafer by the same method as described above. Then, dry etching rates of these resist underlayer films were measured using RIE-10NR (manufactured by Samco Inc.) under conditions in which CF₄ was used as an etching gas. When the dry etching rate of Comparative Example 1 was set to 1.00, the dry etching rate of each of the resist underlayer films was calculated. The results are shown in Table 4 as "relative dry etching rates". In Examples 1 to 4, an increase in etching rate as compared with Comparative Example 1 was observed. From the above results, the etching rate can be increased by introducing a halogeno group.

**[Table 4]**

| | Relative Dry Etching Rate (Comparison with Comparative Example 1 (1.00)) |
|---|---|
| Example 1 | 1.73 |
| Example 2 | 1.71 |
| Example 3 | 1.62 |
| Example 4 | 2.01 |
| Comparative Example 1 | 1.00 |

## Claims

1. A resist underlayer film-forming composition comprising: a novolac resin (A) having a phenolic hydroxy group and a halogen atom directly bonded to an aromatic hydrocarbon ring; and a solvent (B).

2. The resist underlayer film-forming composition according to claim 1, wherein the novolac resin (A) has a repeating unit represented by Formula (1) shown below; 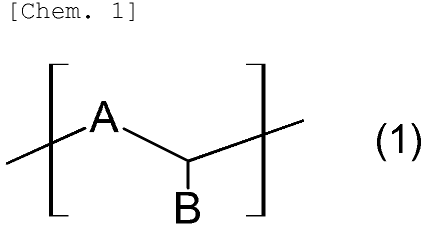
wherein in Formula (1), A represents an aromatic hydrocarbon ring having a phenolic hydroxy group (the aromatic hydrocarbon ring may have a substituent), and
B represents an aromatic hydrocarbon group to which at least one of a bromine atom and an iodine atom is directly bonded (the aromatic hydrocarbon group may have a substituent).

3. The resist underlayer film-forming composition according to claim 2, wherein A in Formula (1) shown above is represented by Formula (1-1) shown below; 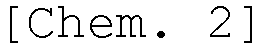 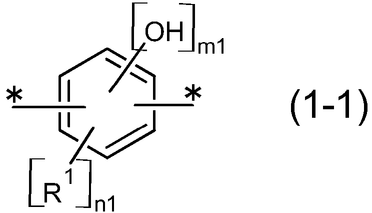
wherein in Formula (1-1), m1 represents an integer of 1 to 4,
n1 represents an integer of 0 to 3,
n1 + m1 is 4 or less,
R¹ represents an alkyl group having 1 to 6 carbon atoms or an alkoxy group having 1 to 6 carbon atoms,
when n1 is 2 or more, two or more R¹'s may be the same or different, and
* represents a bond.

4. The resist underlayer film-forming composition according to claim 2, wherein A in Formula (1) shown above is derived from phloroglucinol which may be substituted.

5. The resist underlayer film-forming composition according to claim 2, wherein B in Formula (1) shown above is represented by Formula (1-2) shown below; 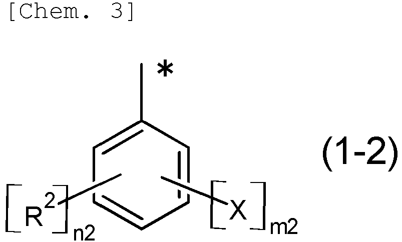
wherein in Formula (1-2), m2 represents an integer of 1 to 5,
n2 represents an integer of 0 to 4,
n2 + m2 is 5 or less,
X represents a bromine atom or an iodine atom,
R² represents a hydroxy group, an alkyl group having 1 to 6 carbon atoms, or an alkoxy group having 1 to 6 carbon atoms,
when n2 is 2 or more, two or more R²'s may be the same or different,
when m2 is 2 or more, two or more X's may be the same or different, and
* represents a bond.

6. The resist underlayer film-forming composition according to claim 1, wherein, in the halogen atom directly bonded to the aromatic hydrocarbon ring, the halogen atom is a bromine atom.

7. The resist underlayer film-forming composition according to claim 1, further comprising a crosslinking agent (C).

8. The resist underlayer film-forming composition according to claim 1, which is a resist underlayer film-forming composition for UV or electron beam lithography.

9. A resist underlayer film which is a cured product of the resist underlayer film-forming composition according to any one of claims 1 to 8.

10. The resist underlayer film according to claim 9, wherein a film thickness is 2 nm or more and 20 nm or less.

11. A laminate comprising:
a semiconductor substrate; and
the resist underlayer film according to claim 9.

12. A semiconductor element producing method comprising the steps of:
forming a resist underlayer film on a semiconductor substrate using the resist underlayer film-forming composition according to any one of claims 1 to 8; and
forming a resist film on the resist underlayer film.

13. A pattern forming method comprising the steps of:
forming a resist underlayer film on a semiconductor substrate using the resist underlayer film-forming composition according to any one of claims 1 to 8;
forming a resist film on the resist underlayer film;
irradiating the resist film with light or electron beams, and then developing the resist film to obtain a resist pattern; and
etching the resist underlayer film using the resist pattern as a mask.
